# EUROPÄISCHE PATENTSCHRIFT

(11) **EP 3 935 705 B1**
(45) Veröffentlichungstag und Bekanntmachung des Hinweises auf die Patenterteilung: **15.05.2024**
(21) Anmeldenummer: 20710900.0
(22) Anmeldetag: 11.03.2020
(51) Int. Cl.: H02H 3/087, H01H 83/20, G01R 15/18

(54) **VERFAHREN ZUM ERKENNEN EINES AUFGRUND EINES FEHLERS HERVORGERUFENEN STROMS**
METHOD FOR DETECTING A CURRENT CAUSED BY A FAULT
PROCÉDÉ POUR DÉTECTER UN COURANT SURVENANT EN RAISON D'UN DÉFAUT

(30) Priorität: 18.04.2019 DE 102019205744
(43) Veröffentlichungstag der Anmeldung: 12.01.2022
(73) Patentinhaber: Ellenberger & Poensgen GmbH, 90518 Altdorf (DE)
(72) Erfinder: BÖSCHE, Dirk, 38536 Seershausen (DE); WILKENING, Ernst-Dieter, 38108 Braunschweig (DE)
(74) Vertreter: FDST Patentanwälte
(86) Internationale Anmeldenummer: PCT/EP2020/056435
(87) Internationale Veröffentlichungsnummer: WO 2020/212021

(56) Entgegenhaltungen:
- EP-A1- 3 242 369
- WO-A1-2016/062427
- DE-A1-102005 007 378
- DE-B3-102016 216 331
- DE-U1-202016 102 682

## Beschreibung

Die Erfindung betrifft ein Verfahren zum Erkennen eines aufgrund eines Fehlers hervorgerufenen Stroms. Der Fehler ist insbesondere ein Lichtbogen. Ferner betrifft die Erfindung eine Vorrichtung zum Erkennen eines aufgrund eines Fehlers hervorgerufenen Stroms sowie einen Schutzschalter.

Innerhalb eines elektrischen Stromkreises können sogenannten Störlichtbögen auftreten. Störlichtbögen sind unerwünschte elektrische Ströme zwischen zumindest einem Element des Stromkreises und einem weiteren Element, wobei zwischen den beiden Elementen eine elektrische Potentialdifferenz existiert. Üblicherweise stehen die beiden Elemente nicht in direktem elektrischem Kontakt, sondern meist befindet sich zwischen diesen eine Isolierung. Ist die Isolierung defekt, indem diese beispielsweise aufgrund von Alterung porös geworden ist oder infolge mechanischen Einwirkens zumindest teilweise entfernt ist, so ist es möglich, dass zwischen den beiden Elementen ein weiterer Stoff eindringt und sich dort anlagert. Dieser Stoff kann flüssig, beispielsweise Wasser, oder gasförmig, insbesondere Luft, sein. Aufgrund der fehlenden Isolationswirkung ist es bei den innerhalb des Stromkreises auftretenden elektrischen Strömen und/oder elektrischen Spannungen möglich, dass ein elektrischer Überschlag, der Störlichtbogen, zwischen den beiden Elementen auftritt. Auch bei Öffnen eines mechanischen Schalters entsteht ein Lichtbogen, der zu einem Abbrand von etwaigen Kontakten des Schalters führen kann.

Der (Stör-)Lichtbogen besteht aus zwei Fußpunkten einer Plasmasäule, die aufgrund einer elektrischen Potentialdifferenz bei Kontakttrennung entsteht, und mittels des Lichtbogens erfolgt ein Führen eines elektrischen Stroms. Aufgrund des Plasmas erfolgt dabei eine Aufheizung der Umgebung, sodass mit einem Brand oder zumindest einer Beschädigung von umliegenden Komponenten zu rechnen ist. Infolgedessen ist es erforderlich, einen auftretenden Störlichtbogen vergleichsweise zeitnah zu erkennen.

Zum Erkennen des Störlichtbogens werden üblicherweise unterschiedliche Verfahren herangezogen. Diese haben meist gemein, dass ein mittels des Stromkreises geführter elektrischer Strom erfasst werden soll. Sofern der Störlichtbogen vorhanden ist, wird mittels dessen meist ein Teil des elektrischen Stroms aus dem Stromkreis ausgeleitet. Falls somit der erfasste elektrische Strom von einer bestimmten Vorgabe abweicht, ist meist ein Störlichtbogen vorhanden.

Zum Erfassen des elektrischen Stroms wird beispielsweise ein Shunt mit einem Messwiderstand verwendet. Hierbei wird eine über den Messwiderstand abfallende elektrische Spannung erfasst, und anhand des bekannten Widerstandswerts des Messwiderstand der elektrische Strom berechnet. Hierbei treten jedoch elektrische Verluste auf, weswegen Betriebskosten erhöht sind. Auch erfolgt eine Erwärmung des Messwiderstands, der somit wiederum gekühlt werden muss. Eine Alternative hierzu sind sogenannte Stromwandler, die jedoch lediglich bei einem Wechselstrom verwendet werden können. Bei einem Gleichstrom hingegen ist es erforderlich, einen Messwandler zu verwenden. Sowohl der Stromwandler als auch der Messwandler sind vergleichsweise komplex aufgebaut und weisen somit vergleichsweise hohe Herstellungskosten auf.

EP 3 242 369 A1 zeigt eine Auslösungsschaltung für Schutzschalter. Hierbei ist eine Stromschiene von einem mit einer Spule umwickelten Kern umgeben.

In DE 10 2005 007 378 A1 ist eine Vorrichtung zur induktiven Gleichstromerfassung offenbart. Es ist ein induktiver Wandler und ein Schaltkreis mit einer Wechselsignalquelle vorgesehen.

DE 10 2016 216 331 B3 zeigt eine Trennvorrichtung zur Stromunterbrechung. Parallel zu einem Schalter sind mehrere Pfade geschaltet, die jeweils ein Widerstandselement aufweisen.

Aus DE 20 2016 102 682 U1 ist ein Schutzschalter zur Gleichstromunterbrechung bekannt. Mittels eines Reed-Relais wird ein elektrischer Stromfluss über einen Hauptstrompfad erfasst.

In WO 2016/062427 A1 ist ein Trennschalters zur galvanischen Gleichstromunterbrechung bekannt. Es ist ein Energiespeicher vorgesehen, der aufgrund eines bei einem Schalten entstehenden Lichtbogens geladen wird.

Der Erfindung liegt die Aufgabe zugrunde, ein besonders geeignetes Verfahren zum Erkennen eines aufgrund eines Fehlers hervorgerufenen Stroms sowie eine besonders geeignete Vorrichtung zum Erkennen eines aufgrund eines Fehlers hervorgerufenen Stroms als auch einen besonders geeigneten Schutzschalter anzugeben, wobei insbesondere eine Erfassungsgeschwindigkeit und/oder eine Robustheit erhöht ist, und wobei zweckmäßigerweise Herstellungskosten und/oder Betriebskosten reduziert sind.

Hinsichtlich des Verfahrens zum Erkennen eines aufgrund eines Fehlers hervorgerufenen Stroms wird diese Aufgabe durch die Merkmale des Anspruchs 1, hinsichtlich der Vorrichtung zum Erkennen eines aufgrund eines Fehlers hervorgerufenen Stroms durch die Merkmale des Anspruchs 5 und hinsichtlich des Schutzschalters durch die Merkmale des Anspruchs 9 erfindungsgemäß gelöst. Vorteilhafte Weiterbildungen und Ausgestaltungen sind Gegenstand der jeweiligen Unteransprüche.

Das Verfahren dient dem Erkennen eines aufgrund eines Fehlers hervorgerufenen Stroms in einem Hauptstrompfad. Mittels des Hauptstrompfad soll bei Betrieb geeigneterweise ein elektrischer Strom, im Weiteren insbesondere als Hauptstrom bezeichnet, geführt werden, der vorzugsweise der Bestromung einer bestimmten Komponente, wie eines Aktors, dient. Der aufgrund eines Fehlers hervorgerufene Strom ergibt sich hierbei insbesondere aufgrund eines Fehlverhaltens des Hauptstrompfads und/oder der etwaigen Komponente. Zum Beispiel ist der aufgrund eines Fehlers hervorgerufenen Stroms ein Überstrom, ein Kurzschlussstrom oder ein Fehlerstrom. Somit weist der Hauptstrompfad und/oder die etwaige Komponente den Fehler auf, der zu dem aufgrund eines Fehlers hervorgerufenen Strom führt. Insbesondere ergibt sich der aufgrund eines Fehlers hervorgerufenen Strom wegen eines Lichtbogens, der sich innerhalb des Hauptstrompfads oder eines mittels des Hauptstrompfads zumindest teilweise gebildeten Stromkreises ausgebreitet hat. Der Fehler ist in diesem Fall insbesondere der Lichtbogen. Der Lichtbogen selbst wird beispielsweise aufgrund einer Betätigung eines Schalters erstellt und überbrückt somit insbesondere zwei getrennte Kontakte oder zumindest Kontakte die getrennt werden. Somit ist der Lichtbogen ein Bestandteil der Schalterstrecke. Alternativ ist der Lichtbogen ein Störlichtbogen, insbesondere ein serieller oder paralleler Störlichtbogen ("seriell arc" / "parallel arc").

Der Hauptstrompfad ist beispielsweise mittels einer elektrischen Leitung gebildet. Zweckmäßigerweise umfasst der Hauptstrompfad eine Stromschiene. Ferner umfasst der Hauptstrompfad eine erste Spule. Die erste Spule ist eine elektrische Spule und weist somit eine Wicklung mit mehreren Windungen auf. Insbesondere ist hierbei die erste (elektrische) Spule auf den mittels des Hauptstrompfads zu führenden (elektrischen) Hauptstrom, insbesondere die mittels des Hauptstrompfads zuführende elektrische Leistung angepasst. Vorzugsweise weist die erste Spule einen vergleichsweise großen Querschnitt auf, sodass ohmsche Verluste reduziert sind. Beispielsweise ist die erste Spule mittels eines Lackdrahts gebildet, beispielsweise eines Kupferlackdrahts oder Aluminiumlackdrahts.

Die erste Spule ist induktiv mit einer zweiten Spule gekoppelt, die jedoch kein Bestandteil des Hauptstrompfades ist. Mit anderen Worten wird mittels der zweiten Spule bei Betrieb des Hauptstrompfads nicht der mittels des Hauptstrompfads geführte elektrische Hauptstrom geführt. Die beiden Spulen sind insbesondere elektrisch zueinander isoliert, sodass ein mittels der erste Spule geführter elektrischer Strom nicht mittels der zweite elektrischen Spulen geführt wird. Die zweite Spule ist ebenfalls eine elektrische Spule. Bevorzugt ist die zweite Spule eine Wicklung und weist insbesondere mehrere Windungen auf. Beispielsweise ist die zweite Spule mittels eines Lackdrahts gebildet, beispielsweise eines Kupferlackdrahts oder Aluminiumlackdrahts. Beispielsweise ist die zweite Spule baugleich zu der ersten Spule. Besonders bevorzugt jedoch unterscheiden sich diese, vorzugsweise zumindest oder lediglich anhand der Anzahl der Windungen. Bevorzugt ist bei der ersten Spule im Vergleich zu der zweiten Spule der Querschnitt des etwaigen die erste Spule bildenden Drahts erhöht, wobei jedoch die Anzahl der Windungen reduziert ist.

Die erste Spule ist induktiv mit der zweiten Spule gekoppelt. Beispielsweise sind diese konzentrisch zueinander angeordnet, und mittels einer der beiden Spulen wird jeweils andere zumindest teilweise umfangsseitig umgeben. Alternativ oder in Kombination hierzu ist zumindest eine der Spulen auf einen Kern gewickelt. Vorzugsweise sind die beiden Spulen auf einen gemeinsamen Kern gewickelt, der beispielsweise U-förmig ausgestaltet ist. Hierbei ist jeder der beiden zueinander parallelen Schenkel des Kerns jeweils einer der Spulen zugeordnet, die auf diesen Schenkel vorzugsweise gewickelt sind. Bevorzugt jedoch ist der Kern ringförmig ausgestaltet. Der Kern selbst ist beispielsweise aus einem Ferrit erstellt. Besonders bevorzugt jedoch ist der Kern aus einem Blechpaket erstellt, das insbesondere mehrere übereinander gestapelt Lagen aufweist, die zweckmäßigerweise jeweils aus einem Trafoblech erstellt sind. Somit sind elektrische Verluste aufgrund von sich ausbildenden Wirbelströmen vermieden. Aufgrund der induktiven Kopplung ergibt sich somit dann, wenn mittels der ersten Spulen ein elektrischer Strom geführt wird, eine Änderung der Induktivität der zweiten Spule.

Elektrisch antiparallel zur zweiten Spule ist eine dritte Spule geschaltet, die mit der zweiten Spule induktiv gekoppelt ist.

Das Verfahren sieht vor, dass an die zweite Spule eine elektrische Spannung angelegt wird. Mit anderen Worten werden die beiden Enden der elektrischen Spulen gegen ein jeweiliges elektrisches Potential geführt, wobei zwischen den beiden elektrischen Potentialen eine Differenz vorherrscht. Zum Beispiel wird als elektrische Potentialdifferenz die elektrische Spannung herangezogen, die an einen etwaigen Stromkreis angelegt wird, den zumindest teilweise der Hauptstrompfad bildet. Beispielsweise ist die zweite Spule elektrisch direkt gegen das jeweilige elektrische Potential geführt, oder besonders bevorzugt über weitere elektrische und/oder elektronische Bauteile.

In einem sich anschließenden Arbeitsschritt wird ein sich aufgrund der angelegten elektrischen Spannung durch die zweite Spule ergebender elektrischer Strom erfasst. Hierbei wird beispielsweise direkt der elektrische Strom bestimmt, insbesondere qualitativ oder quantitativ. Alternativ hierzu erfolgt zumindest eine indirekte Bestimmung des elektrischen Stroms. Zum Beispiel wird die Induktivität der zweiten Spule oder zunächst eine, die Induktivität, also den elektrischen Strom, kennzeichnende andere Größe bestimmt.

In einem nachfolgenden Arbeitsschritt wird der auf diese Weise erfasste elektrische Strom mit einem Grenzwert verglichen. Beispielsweise ist der Grenzwert konstant oder variabel, insbesondere in Abhängigkeit von aktuellen Anforderungen. In Abhängigkeit des Vergleichs wird auf das Vorhandensein des Fehlers geschlossen. Beispielsweise wird bei dem Vergleich zunächst der Betrag des erfassten elektrischen Stroms gebildet und somit der Betrag des elektrischen Stroms mit dem Grenzwert verglichen. Alternativ hierzu erfolgt der Vergleich vorzeichenbehaftet. Insbesondere wird auf das Vorhandensein des Fehlers geschlossen, falls der elektrische Strom größer als der Grenzwert ist. Folglich wird auch die Induktivität der zweiten Spule zur Bestimmung des aufgrund eines Fehlers hervorgerufene Stroms und daher auch des Fehlers herangezogen.

Aufgrund des Verfahrens ist kein zusätzlicher Messwiderstand erforderlich, bei dem bei Betrieb ohmsche Verluste auftreten würden. Somit sind Betriebskosten reduziert. Auch sind die beiden elektrischen Spulen zueinander vorzugsweise galvanisch getrennt. Somit ist es möglich, in dem Hauptstrompfad eine vergleichsweise hohe elektrische Spannung zu führen, wobei der mittels der zweiten Spule geführte elektrische Strom vergleichsweise gering gehalten werden kann. Somit können Herstellungskosten reduziert werden. Auch erfolgt aufgrund der induktiven Kopplung der beiden Spulen bei einem aufgrund eines Fehlers hervorgerufenen Stroms eine im Wesentliches unverzügliche Änderung der Induktivität der zweite Spule und somit des sich ergebenden elektrischen Stroms. Infolgedessen ist eine Zeit zur Bestimmung des Fehlers verringert. Auch sind lediglich vergleichsweise wenige Bauteile erforderlich, was eine Robustheit erhöht.

Insbesondere ist das Verfahren zum Erkennen eines aufgrund eines Fehlers hervorgerufenen Stroms ein Bestandteil eines Verfahrens zum Erkennen eines (Stör- )Lichtbogens. Hierbei wird insbesondere zusätzlich eine an dem Hauptstrompfad anliegende elektrische Spannung erfasst und mit einem zugehörigen Grenzwert verglichen. In Abhängigkeit dieses Vergleichs sowie des Vergleichs des elektrischen Stroms mit dem Grenzwert wird insbesondere auf das Vorhandensein des (Stör-)Lichtbogens geschlossen. In einer weiteren Alternative wird beispielsweise stets dann, wenn der aufgrund eines Fehlers hervorgerufene Strom erkannt wurde auf den (Stör-)Lichtbogen geschlossen. In einer weiteren Alternative wird das Verfahren insbesondere nicht zur Bestimmung von aufgrund eines Fehlers hervorgerufene Strömen sondern zur Bestimmung eines elektrischen Stroms generell herangezogen, also insbesondere zur Bestimmung des Hauptstroms, der mittels des Hauptstrompfads geführt wird. Hierbei wird anhand des erfassten elektrischen Stroms, der sich in der weiten Spule ergibt, insbesondere auf den Hauptstrom geschlossen. Beispielsweise wird hierfür ein Modell und/oder eine Formel herangezogen. Zum Beispiel besteht ein linearer Zusammenhang des Hauptstromstroms mit dem elektrischen Strom. Bei diesem Anwendungsfall erfolgt insbesondere kein Vergleich mit dem Grenzwert.

Zum Beispiel wird als Hauptstrom ein Wechselstrom herangezogen. Somit ergibt sich in der erste Spule ein elektrischer Stromfluss in unterschiedliche Richtungen. Beispielsweise ist hierbei der Wechselstrom ein sinusförmiger Wechselstrom, oder ein sonstiger Wechselstrom, wie ein Sägezahnstrom oder ein Rechteckstrom. Besonders bevorzugt jedoch wird mittels des Hauptstrompfads ein Gleichstrom geführt. Sofern folglich in dem Hauptstrompfad kein Fehler vorliegt, ist der Hauptstrom im Wesentlichen lediglich abhängig von einer etwaigen mittels des Hauptstrompfads bestromt Komponente. Aufgrund des Gleichstroms ergibt sich somit im Wesentlichen keine magnetische Umpolung der ersten Spule, sodass mittels dieser ein im Wesentlichen konstantes Magnetfeld erzeugt wird. Infolgedessen wird in der zweite Spule keine zusätzliche elektrische Spannung induziert, was das Erfassen des elektrischen Stroms vereinfacht.

Zum Beispiel wird an die zweite Spule eine konstante elektrische Spannung angelegt. Besonders bevorzugt jedoch wird an die zweite Spule eine elektrische Wechselspannung angelegt, die beispielsweise sinusförmig ist. Besonders bevorzugt jedoch wird an die zweite Spule eine gepulste elektrische Spannung angelegt. Mit anderen Worten ist die elektrische Spannung mittels derer die zweite Spule beaufschlagt ist, rechteckförmig gepulst. Insbesondere ist hierbei ein Puls-Pausen-Verhältnis im Wesentlichen 1:1, sodass der Zeitabschnitt, während dessen an die zweite Spule die elektrische Spannung angelegt ist, gleich lang mit dem zeitlich nachfolgenden Abschnitt ist, während dessen keine elektrische Spannung an die zweite Spule angelegt wird. Insbesondere wird hierbei das Anlegen der elektrischen Spannung periodisch wiederholt, sodass eine Wechselspannung realisiert ist. Aufgrund der periodisch anliegenden elektrischen Spannung ergibt sich somit ein periodischer elektrischer Strom. Insbesondere wird dieser periodisch erfasst, und zweckmäßigerweise wird auch periodisch der elektrische Strom mit dem Grenzwert verglichen sowie in Abhängigkeit des Vergleichs auf den Fehlerfall geschlossen. Somit ist eine Betriebssicherheit erhöht.

Geeigneterweise ist antiparallel zur zweiten Spule eine dritte Spule elektrisch geschaltet, die beispielsweise baugleich zur zweiten Spule ist. Gemäß der Erfindung ist hierbei die dritte Spule induktiv mit der zweiten Spule gekoppelt. Somit wird bei Anlegen der elektrischen Spannung insbesondere auch an die dritte Spule die elektrische Spannung an gelegt, und/oder aufgrund des sich in der zweiten Spule ergebenden elektrischen Stroms wird auch die dritte Spule mit einem elektrischen Strom durchflossen, wobei sich insbesondere aufgrund der antiparallelen elektrische Schaltung, die beiden sich ergebenden elektrischen Ströme aufheben, wenn die erste Spule nicht bestromt ist. Infolgedessen sind elektrische Verluste reduziert. Falls mittels der ersten Spule der Hauptstrom geführt wird, wird sowohl die Induktivität der zweiten als auch der dritten Spule verändert. Sofern in diesem Fall die elektrische Spannung angelegt wird, unterscheidet sich der sich in der zweiten und dritten Spule ergebenden elektrische Strom, und die Differenz ist Abhängig von veränderten Induktivität.

Besonders bevorzugt wird mittels des elektrischen Stroms ein Energiespeicher geladen. Der Energiespeicher ist beispielsweise eine Batterie oder besonders bevorzugt eine Kapazität, vorzugsweise ein elektrischer Kondensator. Somit steht der elektrische Strom nach dem Erfassen auch weiterhin zur Verfügung, sodass elektrische Verluste reduziert sind. Beispielsweise wird hierbei der Energiespeicher zum Bestromen der etwaigen dritten Spule herangezogen. Besonders bevorzugt erfolgt das Erfassen des sich ergebenden elektrischen Stroms mittels Erfassen der an dem Energiespeicher anliegenden elektrischen Spannung, insbesondere der an dem Kondensator anliegenden elektrischen Spannung. Infolgedessen ist es lediglich erforderlich, eine elektrische Spannung zu erfassen, was Herstellungskosten weiter reduziert.

Die Vorrichtung dient dem Erkennen eines aufgrund eines Fehlers hervorgerufene Stroms, also insbesondere eines ungewollten elektrischen Stroms, wie eines Kurzschluss-, Fehler- oder Überstroms. Alternativ oder in Kombination hierzu dient die Vorrichtung der allgemeinen Bestimmung eines elektrischen Stroms. Die Vorrichtung umfasst einen Hauptstrompfad, der eine erste Spule aufweist. Die erste Spule ist eine elektrische Spule, und somit wird bei einem Stromfluss durch die erste Spule ein Magnetfeld erzeugt. Die erste Spule ist beispielsweise aus einem Draht, vorzugsweise einem Lackdraht, wie einem Kupferlackdraht oder einem Aluminiumlackdraht, erstellt, vorzugsweise gewickelt. Zudem umfasst die Vorrichtung eine zweite Spule, die ebenfalls eine elektrische Spule ist. Die zweite Spule ist induktiv mit der ersten Spule gekoppelt. Somit wird dann, wenn mittels der ersten Spule ein Magnetfeld erzeugt wird, auch die zweite Spule von dem Magnetfeld durchsetzt, was zu einer eine Änderung der Induktivität der zweiten Spule führt, sowie umgekehrt. Insbesondere wird bei einem Beginn einer Bestromung der ersten Spule innerhalb der zweiten Spule eine elektrische Spannung induziert und umgekehrt.

Die Vorrichtung umfasst ferner eine erste Einheit zum Anlegen einer elektrischen Spannung an der zweiten Spule. Hierfür ist die erste Einheit geeignet, insbesondere vorgesehen und eingerichtet. Beispielsweise umfasst die erste Einheit einen Transformator, einen Energiespeicher oder eine sonstige Einheit zum Anlegen der elektrischen Spannung. Beispielsweise ist es hierbei möglich, die Höhe der elektrischen Spannung geeignet auszuwählen. Alternativ hierzu ist die elektrische Spannung beispielsweise konstant.

Ferner umfasst die Vorrichtung eine zweite Einheit zum Erfassen eines sich durch die zweite Spule ergebenden elektrischen Stroms. Hierbei ergibt sich der elektrische Strom aufgrund des Anliegens der elektrischen Spannung mittels der ersten Einheit. Beispielsweise wird mittels der zweiten Einheit der elektrische Strom direkt erfasst. Besonders bevorzugt jedoch wird dieser indirekt erfasst. Beispielsweise erfolgt ein qualitatives oder quantitatives Erfassen des elektrischen Stroms.

Zudem dient die zweite Einheit dem Vergleich des elektrischen Stroms mit einem Grenzwert. Der Grenzwert ist zum Beispiel fest oder abhängig von einer bestimmten weiteren Variablen, die beispielsweise mittels einer Benutzereingabe oder aufgrund eines Betriebszustands oder eines sonstigen externen Ereignisses vorgegeben ist. Beispielsweise wird mittels der zweiten Einheit der elektrische Strom bereits bei Erfassen mit dem Grenzwert verglichen. Zum Beispiel wird hierbei mittels der zweiten Einheit ein binäres Ergebnis ausgegeben, insbesondere in Abhängigkeit davon, ob der elektrische Strom größer als der Grenzwert ist. Falls dies nicht der Fall sein sollte, ist entweder kein elektrischer Strom vorhanden, oder der elektrische Strom ist zumindest kleiner als der Grenzwert.

Ferner weist die Vorrichtung einen Ausgang auf, der mittels der zweiten Einheit in Abhängigkeit des Vergleichs angesteuert ist. Insbesondere liegt an dem Ausgang ein Signal (Pegel) an, wenn der elektrische Strom größer als der Grenzwert ist. Anderenfalls liegt an dem Ausgang kein Signal an. In diesem Fall ist der elektrische Strom entweder unterhalb des Grenzwerts, oder es ist kein elektrischer Strom vorhanden. Somit erfolgt eine binäre Ansteuerung des Ausgangs mittels der zweiten Einheit.

Bei der Vorrichtung ergibt sich somit aufgrund der induktiven Kopplung der beiden Spulen bei Auftritt eines aufgrund eines Fehlers hervorgerufenen Stroms in dem Hauptstrompfad vergleichsweise zeitnah eine Änderung des elektrischen Stroms, sodass eine entsprechende Ansteuerung des Ausgangs erfolgt. Somit ist eine Erfassungsgeschwindigkeit zur Bestimmung des aufgrund eines Fehlers hervorgerufene Stroms /Fehlers erhöht. Auch sind lediglich vergleichsweise wenige Bauteile erforderlich, was eine Robustheit erhöht. Zudem ist es möglich, die zweite Spule galvanisch von der ersten Spule getrennt zu betreiben, weswegen dort vergleichsweise geringe elektrische Ströme/elektrische Spannung gewählt werden können. Somit sind eine Sicherheit und auch eine Robustheit erhöht. Auch sind lediglich vergleichsweise wenige Bauteile vorhanden, weswegen Herstellungskosten reduziert sind. Da im Wesentlichen keine ohmschen Verlusten anfallen, sind zu den Betriebskosten reduziert.

Insbesondere ist der Ausgang im Montagezustand mit einem Eingang eines Schutzschalters oder einer sonstigen Steuerschaltung verbunden. Hierbei wird mittels der Steuerschaltung und/oder des Schutzschalters bei entsprechender Ansteuerung des Ausgangs der Hauptstrom aufgetrennt, sodass ein Hauptstrom durch den Hauptstrompfad unterbrochen wird. Dies erfolgt zweckmäßigerweise dann, wenn ein (Stör-)Lichtbogen oder zumindest der Fehler vorliegt. Somit ist eine Betriebssicherheit erhöht, und der aufgrund eines Fehlers hervorgerufenen Stroms wird beendet. Geeigneterweise umfasst die Vorrichtung einen entsprechenden Anschluss für eine elektrische Leitung, sodass der Hauptstrompfad im Montagezustand insbesondere in einen zu überwachenden elektrischen Schaltkreis eingebracht werden kann.

Beispielsweise dient die Vorrichtung zusätzlich zum Erkennen eines (StörLichtbogens. Hierbei wird insbesondere in Abhängigkeit des Vergleichs, also dann wenn der Ausgang angesteuert ist, auf einen (Stör-)Lichtbogen geschlossen. Bevorzugt in Kombination hierzu wird insbesondere eine an dem Hauptstrompfad anliegende elektrische Spannung als zusätzliches Kriterium zur Beurteilung auf das Vorliegen des (Stör-)Lichtbogens herangezogen. In einer Weiterbildung werden beispielsweise eine zeitliche Änderung der elektrischen Spannung und/oder eine zeitliche Änderung des erkannten aufgrund eines Fehlers hervorgerufene Stroms oder des erfassten elektrischen Stroms zur Beurteilung auf das Vorliegen des (Stör-)Lichtbogens verwendet.

Die Vorrichtung umfasst eine dritte Spule, die induktiv mit der zweiten Spule und somit ebenfalls mit der ersten Spule gekoppelt ist. Somit ergibt sich dann, wenn mittels des Hauptstrompfads der Hauptstrom geführt wird, auch eine Änderung der Induktivität der dritten Spule. Somit steht ein weiteres Bauteil zur Überprüfung des aufgrund eines Fehlers hervorgerufenen Stroms zur Verfügung. Geeigneterweise ist die dritte Spule ein Bestandteil der zweiten Einheit. Besonders bevorzugt sind sämtliche Spulen auf einen gemeinsamen Kern gewickelt, der beispielsweise E-förmig oder ringförmig ausgestaltet ist. Hierbei ist jedem der zueinander parallelen Schenkel vorzugsweise jeweils eine der Spulen zugeordnet.

Die zweite Spule ist elektrisch antiparallel zur dritten Spule geschaltet. Dabei sind die beiden Spulen zweckmäßigerweise derart angeordnet, dass dann, wenn diese aufgrund der angelegten elektrischen Spannung von dem jeweiligen elektrischen Strom durchflossen werden, sich deren beide Magnetfelder aufheben. Somit sind auftretende Verluste bei Betrieb reduziert. Geeigneterweise ist zur dritten Spule eine Diode elektrisch in Reihe geschaltet. Infolgedessen ist lediglich ein Stromfluss in eine bestimmte Richtung durch die dritte Spule ermöglicht. Somit ist es möglich, insbesondere eine Summe des sich durch die zweite und dritte Spule ergebenden elektrischen Stroms, bzw. deren jeweilige Differenz, zu erfassen. Aufgrund der Diode ist es zusätzlich möglich, lediglich den elektrischen Strom, der sich lediglich innerhalb der zweiten Spule ergibt, zu erfassen. Somit sind eine Zuverlässigkeit und eine Sicherheit erhöht.

Alternativ oder besonders bevorzugt in Kombination hierzu ist elektrisch in Reihe zu der zweite Spule ein erste Schaltelement der ersten Einheit geschaltet. Das erste Schaltelement ist insbesondere ein Halbleiterschalter, beispielsweise ein Feldeffekttransistor. Vorzugsweise ist das erste Schaltelement ein MOSFET, oder ein GTO. Somit sind mittels des ersten Schaltelements vergleichsweise schnelle Schaltvorgänge ermöglicht, wobei ein Ausbreiten eines Lichtbogens verhindert ist. Vorzugsweise ist hierbei die dritte Spule vorhanden, die geeigneterweise elektrisch parallel zur Reihenschaltung aus der zweiten Spule sowie dem ersten Schaltelement geschaltet ist. Besonders bevorzugt ist dabei die zur Reihenschaltung aus der zweiten Spule sowie dem ersten Schaltelement elektrisch parallel zu der Reihenschaltung aus der dritten Spule sowie der etwaigen Diode geschaltet. Vorzugsweise sind die zweite Spule sowie das erste Schaltelement zwischen zwei festen elektrischen Potentialen geschaltet, beispielsweise Masse und einem Referenzpotential. Somit wird bei Betätigung des ersten Schaltelements an der erste Spule die elektrische Spannung angelegt, und bei Öffnen des ersten Schaltelements das Anlegen beendet. Infolgedessen wird insbesondere die erste Spule bei Betrieb mittels einer elektrischen Rechteckspannung beaufschlagt.

Vorzugsweise ist das erste Schaltelement mittels eines Taktgebers der ersten Einheit betätigt. Vorzugsweise wird mittels des Taktgebers ein periodisches Signal erzeugt. Infolgedessen ist das erste Schaltelement im Wesentlichen für eine erste Zeitspanne geschlossen und eine nachfolgende zweite Zeitspanne geöffnet, wobei sich diese beiden Zeitspannen stets abwechseln. Insbesondere ist aufgrund der Wahl des Takts die Länge der Zeitspannen gleich. Mit anderen Worten wird mittels der ersten Einheit eine periodisch wiederkehrende Rechteckspannung angelegt, also eine Wechselspannung. Somit ist es möglich, mittels der zweiten Einheit periodisch den sich ergebenden elektrischen Strom zu erfassen. Sofern dabei die etwaige Diode elektrisch in Reihe zur dritten Spule geschaltet ist, wird insbesondere lediglich bei einem der beiden Zeitfenster die dritte Spule von dem elektrischen Strom durchflossen.

Besonders bevorzugt ist elektrisch parallel zur zweite Spule ein Energiespeicher der zweite Einheit geschaltet. Insbesondere ist das erste Schaltelement vorhanden, und der Energiespeicher zweckmäßigerweise parallel zur zweite Spule sowie zu dem ersten Schaltelement geschaltet. Der Energiespeicher ist zweckmäßigerweise ein Kapazität, wie ein elektrischer Kondensator. Vorzugsweise wird der elektrische Strom, der sich durch die zweite Spule ergibt, anhand der elektrischen Ladung des Energiespeicher ermittelt, also der an dem Energiespeicher anliegenden elektrischen Spannung, nachfolgend auch als Ladespannung bezeichnet. Somit erfolgt das Erfassen des elektrischen Stroms mittels Erfassen der elektrischen Ladespannung, was mittels vergleichsweise kostengünstiger Bauteile erfolgen kann. Somit sind Herstellungskosten reduziert. Zum Beispiel wird zu Beginn der Benutzung der Vorrichtung der Energiespeicher bereits auf einen bestimmten Wert geladen. Somit ist während des Betriebs der Vorrichtung die bei Abwesenheit des aufgrund eines Fehlers hervorgerufenen Stroms an dem Energiespeicher anliegende elektrische Spannung im Wesentlichen konstant, was eine Weiterverarbeitung vereinfacht.

Alternativ oder in Kombination hierzu wird der Energiespeicher beispielsweise zum Anlegen der elektrischen Spannung an der zweiten und/oder dritten Spule herangezogen. Somit ist der Energiespeicher beispielsweise ein Bestandteil der ersten Einheit. Insbesondere wird der sich aufgrund des Anlegens der elektrischen Spannung ergebende elektrische Strom zur Ladung des Energiespeichers verwendet, was elektrische Verluste reduziert. Vorzugsweise wird bei einem etwaigen erneuten Anlegen der elektrischen Spannung an die zweite Spule die an dem Energiespeicher anliegende elektrische Spannung verwendet.

Besonders bevorzugt umfasst die zweite Einheit einen Zweig, der parallel zum Energiespeicher geschaltet ist. Der Zweig umfasst insbesondere ein zweites Schaltelement, das in Abhängigkeit einer über den Energiespeicher anfallenden elektrischen Spannung, also der Ladespannung, betätigt ist. Vorzugsweise wird hierbei das zweite Schaltelement in den elektrisch leitfähigen Zustand versetzt, sofern die Ladespannung größer als ein bestimmter Wert ist, der zweckmäßigerweise zu dem Grenzwert korrespondiert. Somit wird dann, wenn der Vergleich des elektrischen Stroms mit dem Grenzwert positiv ist, das zweite Schaltelement in den elektrisch leitenden Zustand versetzt. Dabei erfolgte die Bestimmung des elektrischen Stroms anhand der Ladespannung des Energiespeichers, und der Grenzwert ist entsprechend angepasst.

Vorzugsweise ist der Ausgang gegen den Zweig geführt. Somit liegt dann, wenn das zweite Schaltelement elektrisch leitend ist, an dem Ausgang eine Pegel an.

Vorzugsweise sind hierbei zusätzliche Widerstände vorhanden, insbesondere eine Widerstandskette. Infolgedessen ist der an dem Ausgang anliegende Pegel, der zum Beispiel eine elektrische Spannung ist, im Vergleich zu Ladespannung reduziert, sodass eine Weiterverarbeitung vereinfacht ist.

Das zweite Schaltelement ist vorzugsweise ein Halbleiterschalter, beispielsweise in Feldeffekttransistor, wie ein MOSFET. Auf diese Weise sind vergleichsweise schnelle Schaltvorgänge ermöglicht. Auch ist ein Ausbilden eines Lichtbogens verhindert. Geeigneterweise ist das etwaige Gate gegen einen Mittenabgriff eines Spannungsteilers des Zweigs aufweist, der elektrisch in Reihe zu dem zweiten Schaltelement geschaltet ist. Vorzugsweise ist hierbei der Ausgang auf der dem Spannungsteiler gegenüberliegenden Seite des zweiten Schaltelements gegen den Zweig geführt und vorzugsweise mit dem Zweig elektrisch direkt kontaktiert. Vorzugsweise ist auch dort ein weiterer ohmscher Widerstand vorhanden, sodass die an dem Ausgang anliegende elektrische Spannung reduziert ist.

Zum Beispiel ist der Spannungsteiler mit einer Diode und/oder einem weiteren Schaltelement überbrückt. Mittels des weiteren Schaltelements erfolgt insbesondere eine Vorladung des Energiespeichers, sodass bei Beginn der Verwendung der Vorrichtung bereits an dem Energiespeicher die Ladespannung anliegt. Insbesondere erfolgt mittels der etwaigen Diode eine Begrenzung der an dem Energiespeicher anliegenden Ladespannung, sodass eine Überbelastung vermieden ist.

Der Schutzschalter dient insbesondere der Absicherung einer elektrischen Leitung und/oder einer Komponente, wie eines Aktors. Der Schutzschalter umfasst ein dritte Schaltelement, beispielsweise ein Relais, einen Halbleiterschalter oder eine Kombination hieraus ist. Beispielsweise ist das etwaige Relais elektrisch parallel oder in Reihe zu dem Halbleiterschalter geschaltet. Zum Beispiel ist der Halbleiterschalter ein Feldeffekttransistor, wie ein MOSFET, ein IGBT oder ein GTO.

Ferner umfasst der Schutzschalter eine Vorrichtung zum Erkennen eines aufgrund eines Fehlers hervorgerufenen Stroms, wobei das dritte Schaltelement mittels einer Vorrichtung betätigt ist, beispielsweise direkt. Die Vorrichtung zum Erkennen eines aufgrund eines Fehlers hervorgerufenen Stroms umfasst einen Hauptstrompfad, mittels dessen bei ordnungsgemäßem Betrieb ein elektrischer Strom (Hauptstrom) geführt wird. Im Montagezustand ist der Hauptstrompfad ein Bestandteil eines elektrischen Schaltkreises, der mittels des Schutzschalters zweckmäßigerweise abgesichert werden soll. Vorzugsweise umfasst der Hauptstrompfad endseitig einen geeigneten Anschluss an eine elektrische Leitung, wie eine Klemme oder einen Stecker. Zweckmäßigerweise ist das dritte Schaltelement ein Bestandteil des Hauptstromfahrrads. Somit ist es möglich, mittels des dritten Schaltelements einen Stromfluss durch den Hauptstrompfad zu unterbrechen und/oder zu erstellen.

Der Hauptstrompfad umfasst ferner eine erste Spule, die beispielsweise elektrische in Reihe zu dem dritten Schaltelement geschaltet ist. Die erste Spule ist induktiv mit einer zweiten Spule gekoppelt ist. Hierbei sind die beiden Spule elektrisch zueinander isoliert, beispielsweise galvanisch. Geeigneterweise sind die beiden Spulen auf einen gemeinsamen Kern gewickelt.

Ferner umfasst die Vorrichtung eine erste Einheit zum Anlegen einer elektrischen Spannung an der zweite Spule sowie eine zweite Einheit zum Erfassen eines sich durch die zweite Spule ergebenden elektrischen Stroms und zum Vergleich des elektrischen Stroms mit einem Grenzwert. Ferner umfasst die Vorrichtung einen Ausgang, der mittels der zweiten Einheit in Abhängigkeit des Vergleichs angesteuert ist.

Insbesondere ist ein Steuereingang des dritten Schaltelements, wie beispielsweise ein Gate des etwaigen Halbleiterschalters, signaltechnisch mit dem Ausgang gekoppelt. Vorzugsweise ist der Steuereingang des dritten Schaltelements elektrisch gegen den Ausgang geführt. Somit wird insbesondere das dritte Schaltelement dann, wenn an dem Ausgang bestimmter Pegel anliegt, geöffnet und folglich ein elektrischer Stromfluss durch den Hauptstrompfad unterbrochen. Hierbei liegt insbesondere an dem Ausgang ein zum Öffnen des dritten Schaltelements führender Pegel an, wenn der Fehler erkannt wurde.

Die im Zusammenhang mit dem Verfahren zum Erkennen eines aufgrund eines Fehlers hervorgerufene Stroms/ Verfahren zum Erkennen eines (StörLichtbogens / Verfahren zur Bestimmung eines elektrischen Stroms ausgeführten Weiterbildungen und Vorteile sind sinngemäß auch auf die Vorrichtung zum Erkennen eines aufgrund eines Fehlers hervorgerufene Stroms/ (Stör-)Lichtbogens und/oder den Schutzschalter zu übertragen sowie umgekehrt als auch untereinander.

Sofern ein Bauteil als erstes, zweites, drittes, ... Bauteil bezeichnet wird, ist insbesondere lediglich darunter ein bestimmtes Bauteil zu verstehen. Insbesondere bedeutet dies nicht, dass eine bestimmte Anzahl an derartigen Bauteilen vorhanden ist. So impliziert insbesondere nicht, dass das erste Schaltelement vorhanden ist, sofern das zweite Schaltelement vorhanden ist.

Nachfolgend wird ein Ausführungsbeispiel der Erfindung anhand einer Zeichnung näher erläutert. Darin zeigen:
- Fig. 1: schematisch einen Schutzschalter mit einer Vorrichtung zum Erkennen eines aufgrund eines Fehlers hervorgerufene Stroms,
- Fig. 2: ein Verfahren zum Erkennen eines (Stör-)Lichtbogens, das ein Verfahren zum Erkennen eines aufgrund eines Fehlers hervorgerufene Stroms aufweist, und
- Fig. 3: einen vereinfachten Schaltplan der Vorrichtung zum Erkennen eines aufgrund eines Fehlers hervorgerufene Stroms.

Einander entsprechende Teile sind in allen Figuren mit den gleichen Bezugszeichen versehen.

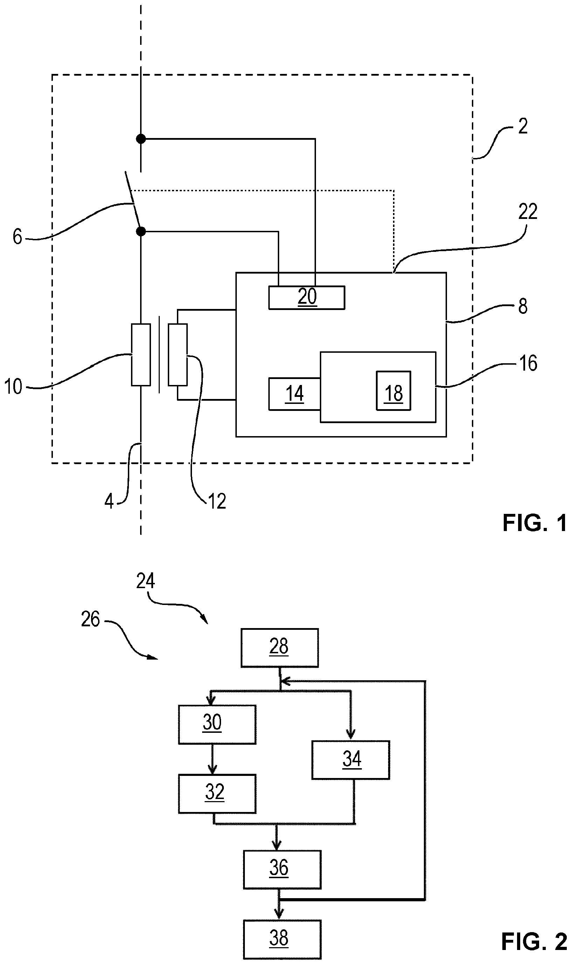

In Figur 1 ist schematisch vereinfacht ein Schutzschalter 2 mit einem Hauptstrompfad 4 gezeigt, der im bestimmungsgemäßen Zustand in einen elektrischen Stromkreis eingebracht ist, der mittels des Schutzschalters 2 abgesichert werden soll. Im Montagezustand ist der Hauptstrompfad 4 ein Bestandteil des elektrischen Stromkreises, und der Hauptstrompfad 4 weist geeignete Anschlussstecker und/oder Terminals zur elektrischen Kontaktierung der weiteren Bestandteile des Stromkreises auf.

Der Hauptstrompfad 4 weist ein drittes Schaltelement 6 auf, das mittels einer Vorrichtung 8 zum Erkennen eines aufgrund eines Fehlers hervorgerufenen Stroms betätigt ist. Der Hauptstrompfad 4 ist dabei mittels der Vorrichtung zum Erkennen des aufgrund eines Fehlers hervorgerufenen Stroms 8 bereitgestellt, oder zumindest ein Bestandteil des Hauptstrompfads4 ist mittels der Vorrichtung 8 gebildet. Das dritte Schaltelement 6 ist in diesem Beispiel ein Relais oder ein Halbleiterschalter, insbesondere deinen Leistungshalbleiterschalter, wie ein MOSFET. In einer nicht näher dargestellten Variante ist das dritte Schaltelement 6 mittels einer Verschaltung eines Relais mit einem Halbleiterschalter gebildet oder umfasst zumindest diese. Bei Öffnen des dritten Schaltelements 6 wird hierbei ein elektrischer Stromfluss, im Weiteren insbesondere als Hauptstrom bezeichnet, durch den Hauptstrompfad 4 unterbrochen, sodass mittels dessen kein Hauptstrom mehr geführt werden kann, der zum Betrieb des elektrischen Schaltkreises verwendet wird.

Der Hauptstrompfad 4 weist ferner eine erste Spule 10 auf, die induktiv mit einer zweiten Spule 12 der Vorrichtung 8 gekoppelt ist. Hierfür sind die beiden Spulen 10, 12 auf einen nicht näher dargestellten gemeinsamen ringförmigen Kern gewickelt, der aus einem Blechpaket erstellt ist. Die beiden Spulen 10,12 sind zueinander elektrisch isoliert. Zudem weist die Vorrichtung 8 eine erste Einheit 14 zum Anlegen einer elektrischen Spannung an der zweiten Spule 12 auf. Die mittels der ersten Einheit 14 bereitgestellte elektrische Spannung ist hierbei eine gepulste elektrische Spannung, wobei die Höhe der elektrischen Spannung stets konstant ist.

Ferner umfasst die Vorrichtung 8 eine zweite Einheit 16 zum Erfassen eines sich durch die zweite Spule 12 ergebenden elektrischen Stroms. Ferner dient die zweite Einheit 16 dem Vergleich des erfassten elektrischen Stroms mit einem Grenzwert. Zudem weist die zweite Einheit 16 einen Energiespeicher 18 in Form eines elektrischen Kondensators auf, wobei bei Betrieb der Energiespeiche mittels des durch die zweite Spule 12 fließenden elektrischen Stroms geladen wird.

Ferner weist die Vorrichtung 8 eine Spannungsmessvorrichtung 20 auf, mittels derer eine über das dritte Schaltelement 6 abfallende elektrische Spannung erfasst werden kann. Die Spannungsmessvorrichtung 20 ist mit der zweiten Einheit 16 signaltechnisch gekoppelt, und mittels dieser wird in Abhängigkeit der mittels der Spannungsmessvorrichtung 20 erfassten elektrischen Spannung und/oder eines Vergleichs dieser elektrischen Spannung mit einem weiteren Grenzwert sowie des Vergleichs des elektrischen Stroms mit dem Grenzwert ein Ausgang 22 angesteuert. Alternativ hierzu ist eine zusätzliche Steuerungslogik vorhanden, die sowohl mittels der zweiten Einheit 16 als auch mit der Spannungsmessvorrichtung 20 beaufschlagt ist. Hierbei erfolgt der Vergleich elektrischen Spannung mit dem weiteren Grenzwert sowie die Ansteuerung des Ausgangs 22 in Abhängigkeit dieses Vergleichs sowie in Abhängigkeit des mittels der zweiten Einheit 16 erstellten Vergleichs mittels der Steuerungslogik. Somit wird mittelbar mittels der zweiten Einheit 16 der Ausgang 22 angesteuert. Das dritte Schaltelement 6, insbesondere ein Steuereingang des dritten Schaltelements 6, ist gegen den Ausgang 22 geführt, sodass dann, wenn an dem Ausgang 22 ein bestimmter Pegel anliegt, insbesondere eine bestimmte elektrische Spannung, das dritte Schaltelement 6 geöffnet wird.

In Figur 2 ist ein Verfahren 24 zum Erkennen eines (Stör-)Lichtbogens 24 gezeigt, dass ein Verfahren 26 zum Erkennen eines aufgrund eines Fehlers hervorgerufenen Stroms aufweist. Der Lichtbogen ergibt sich beispielsweise aufgrund der Betätigung eines mechanischen Schalters oder aufgrund einer fehlerhaften Isolierung und ist daher ein Störlichtbogen. Insbesondere ist der Schutzschalters 2 gemäß dem Verfahren 24 zum Erkennen des (Stör-)Lichtbogens betrieben. In einem ersten Arbeitsschritt 28 wird mittels des Hauptstrompfads 4 ein Gleichstrom geführt. Hierbei befindet sich das dritte Schaltelement 6 in dem elektrisch geschlossenen Zustand, und eine etwaiger mit dem elektrischen Schaltkreis bestromte Komponente, wie ein Aktor, wird betrieben.

Hierbei wird auch die Vorrichtung 8 zum Erkennen des aufgrund eines Fehlers hervorgerufenen Stroms bestromt und folglich auch die erste Spule 10. Infolgedessen bildet sich ein im Wesentlichen konstantes Magnetfeld aus. Aufgrund der induktiven Kopplung mit der zweiten Spule 12 wird dabei die zweite Spule 12 ebenfalls mittels des Magnetfelds durchsetzt. Aufgrund des konstanten Magnetfelds wird hierbei die Induktivität der zweiten Spule 12 verändert. Sofern die Windungsanzahl der erste und/oder zweite Spule 10, 12 und/oder deren gemeinsamer Kern, auf den die beiden Spuren 10, 12 gewickelt sind, geeignet gewählt sind, wird hierbei beispielsweise bereits eine Sättigung realisiert. Zumindest jedoch ist das Magnetfeld, und daher auch die Änderung der Induktivität der zweiten Spule 12, abhängig von dem Hauptstrom. Sofern folglich aufgrund eines Fehlverhaltens der Komponente oder eines sonstigen Bestandteils des elektrischen Schaltkreises ein aufgrund eines Fehlers hervorgerufener Strom vorliegt, sind auch das Magnetfeld sowie die Induktivität der zweiten Spule 12 verändert.

In einem sich anschließenden zweiten Arbeitsschritt 30 wird mittels der ersten Einheit 14 an der zweiten Spule 12 die elektrische Spannung angelegt. Hierbei wird eine im Wesentlichen konstante elektrische Spannung verwendet, die nach einer bestimmten Zeitspanne abgeschaltet wird. Vor oder nach Abschalten der elektrischen Spannung, wird in einem dritten Arbeitsschritt 32 mittels der zweiten Einheit 16 der sich aufgrund der angelegten elektrischen Spannung ergebende elektrische Strom durch die zweite Spule 12 erfasst. Dieser wird insbesondere zum Laden des Energiespeichers 18 herangezogen, sodass der elektrische Strom, also die daraus resultierende elektrische Spannung im Anschluss weiterhin zur Verfügung steht. Auch wird hierbei der elektrische Strom mittels Erfassen der an dem Energiespeicher 18 anliegende elektrische Spannung, nachfolgend als Ladespannung bezeichnet, erfasst.

Zudem wird mittels der zweiten Einheit 16 der erfasste elektrische Strom mit dem Grenzwert verglichen, der abhängig von dem Hauptstrom ist, oder beispielsweise bei Fertigung des Schutzschalters 2 hinterlegt wurde. In einer weiteren Alternative ist es beispielsweise möglich, den Grenzwert nutzerseitig zu verändern. Sofern der erfasste elektrische Strom größer als der Grenzwert ist, ist auf den Fehler geschlossen, und mittels der zweiten Einheit 16 wird ein entsprechendes Signal ausgegeben. Somit wird in dem dritten Arbeitsschritt 32 auf das Vorhandensein des Fehlers geschlossen, der nämlich dann vorliegt, wenn der elektrische Strom größer als der Grenzwert ist.

In einem vierten Arbeitsschritt 34 der im Wesentlichen zeitgleich zu dem zweiten und dritten Arbeitsschritt 30, 32 erfolgt, wird mittels der Spannungsmessvorrichtung 20 die über das dritte Schaltelement 6 abfallende elektrische Spannung, insbesondere auch als Hauptspannung bezeichnet, erfasst und mit dem weiteren Grenzwert verglichen. Alternativ hierzu wird beispielsweise mittels der Spannungsmessvorrichtung 20 die Potentialdifferenz zwischen dem Hauptstrompfad 4 und einem Referenzpotential, wie Masse oder Erde, erfasst und mit dem weiteren Grenzwert verglichen.

In einem sich anschließenden fünften Arbeitsschritt 36 wird überprüft, ob sowohl der elektrische Strom größer als der Grenzwert ist, also ob mittels der zweiten Einheit 16 ein entsprechendes Signal geliefert wurde, und ob mittels des Spannungsmessvorrichtung 20 ein entsprechendes Signal geliefert wurde, also ob die Potentialdifferenz größer als der weitere Grenzwert ist. Die beiden positiven Ergebnisse der Vergleiche werden insbesondere als Bedingung für einen (StörLichtbogen herangezogen. Sofern somit die beiden Vergleiche positiv sind, ist insbesondere der Fehler, also zweckmäßigerweise der (Stör-)Lichtbogen bestimmt. In einer weiteren Alternative erfolgt zur Realisierung der Bedingung beispielsweise eine Auswertung der Änderung des aufgrund eines Fehlers hervorgerufenen Stroms und/oder der an dem Hauptstrompfad 4 anliegende elektrische Spannung. Somit wird insbesondere ein zeitlicher Verlauf des aufgrund eines Fehlers hervorgerufenen Stroms / der Hauptspannung überprüft.

Zusammenfassend ist stets dann, wenn die Bedingung erfüllt ist, der (StörLichtbogen erkannt, und es wird ein sechster Arbeitsschritt 38 durchgeführt. Bei diesem wird der Ausgang 22 derart angesteuert, dass das dritte Schaltelement 6 geöffnet wird. Somit wird der Stromfluss durch den Hauptstrompfad 4 unterbrochen.

Falls die Bedingung hingegen nicht erfüllt ist, wird wiederum der zweite und dritte Arbeitsschritt 30, 32 durchgeführt. Folglich wird wiederum die elektrische Spannung angelegt. Aufgrund der mehrfachen Wiederholung des zweiten Arbeitsschritts 30 ergibt sich somit eine gepulste elektrische Spannung, die an der zweiten Spule 12 angelegt wird. Ferner wird ebenfalls auch der vierte und fünfte Arbeitsschritt 34, 36 erneut durchgeführt und ebenfalls so lange wiederholt, bis entweder mittels des Hauptstrompfads 4 kein Hauptstrom mehr geführt wird, oder die Bedingung erfüllt ist.

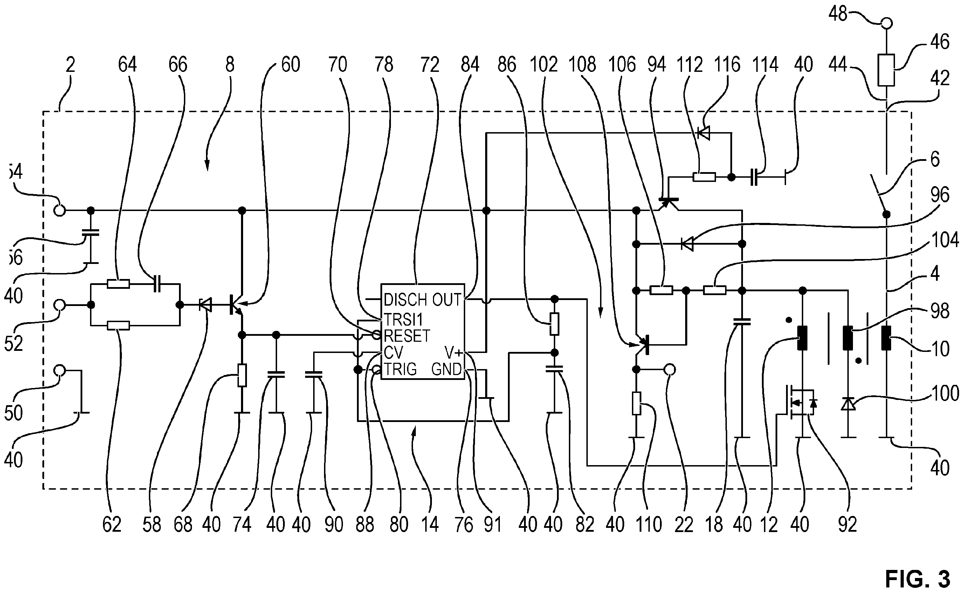

In Figur 3 ist eine vergleichsweise detaillierte Verschaltung des Schutzschalters 2 mit dem Hauptstrompfad 4 gezeigt, der das dritte Schaltelement 6 und die erste Spule 10 umfasst. Der Hauptstrompfad 4 ist zwischen Masse 40 und einer Anschlussklemme 42 des Schutzschalters 2 angeordnet. An der Anschlussklemme 42 ist eine elektrische Leitung 44 angeschlossen, die zu einer Komponente 46 führt, die bestromt werden soll. Hierfür ist die Komponente 46 gegen ein weiteres elektrisches Potential 48 geführt. Während des Betriebs, also wenn das dritte Schaltelement 6 geschlossen ist, ist der Hauptstrom von dem weiteren elektrischen Potential 48 zu Masse 40 gerichtet, wobei ein Gleichstrom vorhanden ist.

Die Vorrichtung 8 zum Erkennen des aufgrund eines Fehlers hervorgerufenen Stroms weist einen erste Klemme 50, eine zweite Klemme 52 und eine dritte Klemme 54 auf. Hierbei ist die erste Klemme 50 ebenfalls gegen Masse 40 geführt, und die dritte Klemme 54 ist gegen das weitere elektrische Potential 48 geführt, sodass an der dritte Klemme 54 ebenfalls das weitere elektrische Potential 48 angelegt ist. In einer weiteren nicht näher dargestellte Variante, insbesondere sofern als Hauptstrom ein Wechselstrom herangezogen wird, ist der dritte Klemme 54 ein Gleichrichter, wie ein Brückengleichrichter, vorgeschaltet, oder die dritte Klemme 54 ist direkt gegen einen (Brücken-)Gleichrichter geführt, sodass im Anschluss daran ein Gleichstrom bzw. eine elektrische Gleichspannung bereitgestellt ist. Der dritten Klemme 54 elektrisch nachgeschaltet ist eine Glättungskondensators 56, der ebenfalls gegen Masse 40 geführt ist. Sofern der Gleichrichter vorhanden ist, ist dieser zweckmäßigerweise zwischen die dritte Klemme 54 und den Glättungskondensator 56 geschaltet.

Falls an die zweite Klemme 52 eine elektrische Spannung angelegt wird, die größer als eine Sperrspannung einer Zener-Diode 58 ist, wird ein viertes Schaltelement 60, das ein Transistor ist, in den elektrisch leitfähigen Zustand versetzt. Hierfür ist die Zener-Diode 58 entsprechend zwischen der zweiten Klemme 52 und dem vierte Schaltelement 60 angeordnet und dort mit dem Gate elektrisch kontaktiert. Zwischen der zweiten Klemme 42 und der Zener-Diode 58 ist eine Parallelschaltung aus einem ersten Widerstand 62 und einer Reihenschaltung aus einem zweiten Widerstand 64 sowie einem ersten Kondensators 66 geschaltet. Hierbei ist der erste Widerstand 20 vergleichsweise hochohmig ausgestaltet. Infolgedessen ist auch bei einer vergleichsweise großen elektrischen Spannung, die an der zweite Klemme 20 angelegt ist, eine an der Zener-Diode 58 wirkende elektrische Spannung reduziert, sodass vergleichsweise kostengünstige Bauteile herangezogen werden können. Damit auch vergleichsweise schnelle Änderungen der elektrischen Spannung, die an der zweite Klemme 20 anliegt, erfasst werden können, ist die Reihenschaltung des zweiten Widerstands 54 und des ersten Kondensators 66 vorhanden, mittels derer der erste Widerstand 20 überbrückt ist. Auf diese Weise ist es möglich, vergleichsweise hohe Basisströme für das vierte Schaltelement 60 bereitzustellen.

Das vierte Schaltelement 60 ist zwischen die dritte Klemme 54 und einen dritten Widerstand 68 geschaltet, der gegen Masse 40 geführt ist. Auch ist sowohl der dritte Widerstand 68 als auch das dritte Schaltelement 60 gegen einen invertierten Rücksetzeingang 70 (RESET) eines Taktgebers 72 der ersten Einheit 14 geführt. Der Taktgeber 72 ist ein NE555 Timer-Baustein und als Rechteckgenerator verschaltet. Sofern das vierte Schaltelement 60 elektrisch leitfähig ist, und über den dritte Widerstand 68 eine elektrische Spannung abfällt, die einen bestimmten Wert überschreitet, insbesondere 0,6 V, wird das stete Zurücksetzten des Taktgebers 72 aufgehoben und dieser somit aktiviert. Zur Vermeidung von einem ungewollten Zurücksetzen des Taktgebers 72 aufgrund einer an der zweiten Klemme 52 schwankenden elektrischen Spannung, insbesondere aufgrund von Spannungsspitzen, ist der Rücksetzeingang 70 ferner mittels eines zweiten Kondensators 74 gegen Masse 40 geführt.

Ein Erdungseingang 76 (GND) des Taktgebers 72 ist gegen Masse 40 geführt. Auch ist ein Schwellwerteingang 78 (TRSH) und ein invertierter Zähleingang 80 (TRIG) gemeinsam gegen einen vierten Kondensator 82 geführt, dessen verbleibende Elektrode gegen Masse 40 geführt ist. Ein Ausgang 84 (OUT) des Taktgebers 72 ist über einen vierten Widerstand 86 ebenfalls gegen den invertierten Zähleingang 80 und somit auch gegen den dritten Kondensator 82 geführt. Mittels geeigneter Wahl der Werte für den dritten Kondensator 82 sowie den vierten Widerstand 86 wird hierbei die Frequenz des mittels des Taktgebers 72 erstellten Ausgangssignals eingestellt, das an dem Ausgang 84 anliegt. Zudem ist ein Kontrolleingang 88 (CTRL, CV) über einen vierten Kondensator 90 gegen Masse 40 geführt. Ein Versorgungsspannungseingang 91 (V+) des Taktgebers 72 ist gegen die dritte Klemme 54 geführt.

Der Ausgang 84 ist ferner mit einem Steuereingang eines ersten Schaltelements 92 kontaktiert, das zwischen Masse 40 und die zweite Spule 12 geschaltet ist. Somit ist die zweite Spule 12 elektrisch in Reihe mit dem ersten Schaltelement 92 der ersten Einheit 14 geschaltet, wobei das erste Schaltelement 92 mittels des Taktgebers 72 betätigt ist. Das erste Schaltelement 92 ist bevorzugt ein MOSFET. Die zweite Spule 12 ist über ein weiteres Schaltelement 94, zu dem elektrisch parallel eine weitere Diode 96 geschaltet ist, gegen die dritte Klemme 54 geführt. Das weitere Schaltelement 94 ist ein Transistor. Bei Betrieb wird dann, wenn beispielsweise das weitere Schaltelement 94 geschlossen ist, und das erste Schaltelement 92 mittels des Taktgebers 72 getaktet betätigt wird, ein getakteter Stromfluss durch die zweite Spule 12 erstellt.

Elektrisch parallel zur zweiten Spule 12 und dem ersten Schaltelement 92 ist der Energiespeicher 18 geschaltet, und antiparallel hierzu eine elektrische Reihenschaltung einer dritten Spule 98 und einer Diode 100. Alle drei Spulen 10, 12, 98 sind auf einen gemeinsamen Ringkern gewickelt und somit induktiv miteinander gekoppelt.

Parallel zu dem Energiespeicher 18 ist ein Zweig 102 der zweiten Einheit 16 geschaltet, der eine elektrische Reihenschaltung aus einem fünften Widerstand 104, einem sechsten Widerstand 106, einem zweiten Schaltelement 108 und einem siebten Widerstands 110 aufweist. Das zweite Schaltelement 108 ist insbesondere ein Transistor. Mittels der Reihenschaltung aus dem fünften und sechsten Widerstand 104, 106 ist die weitere Diode 96 überbrückt, die somit ebenfalls mittels des zweiten Schaltelements 108 sowie des siebten Widerstands 110 gegen Masse geführt ist. Der Ausgang 22 der Vorrichtung 8 ist elektrisch gegen den Zweig 102 geführt, nämlich zwischen dem zweiten Schaltelement 108 und dem siebten Widerstand 110. Das zweite Schaltelement 108 ist als MOSFET ausgestaltet, dessen Steuereingang ebenfalls gegen den Zweig 102 geführt ist, nämlich zwischen dem fünften Widerstand 104 und dem sechsten Widerstand 106.

Falls die erste Spule 10 von keinem elektrischen Strom durchflossen wird, also wenn Hauptstrom 0 A beträgt, wird mittels der ersten Spule 10 kein Magnetfeld erstellt, und somit der Kern nicht magnetisiert. Folglich wird auch eine Induktivität der zweiten und dritten Spule 12, 98 nicht beeinflusst. Daher ist die induktive Kopplung zwischen der zweiten und dritten Spule 12, 98 nahezu 1. Wenn in diesem Fall das erste Schaltelement 92 betätigt wird, also der Taktgeber 72 betrieben wird, wird an die zweite Spule 12 die elektrische Spannung angelegt, weswegen durch diese der elektrische Strom fließt. Aufgrund dessen bildet sich ein Magnetfeld aus, das den Kern magnetisiert. Wenn nun das erste Schaltelement 92 abgeschaltet wird, bricht der elektrische Stromfluss und auch der magnetische Fluss im Kern zusammen, und die in der zweiten Spule 12 gespeicherte elektrische Energie wird über die Diode 100 sowie die dritte Spule 98 in den Energiespeicher 18 zurück gespeist. Wenn der Tastgrad der Ansteuerung des ersten Schaltelements 92, also des Steuersignals, das mittels des Taktgebers 72 bereitgestellt wird, 50 % entspricht, also wenn die Zeitspanne, in der das erste Schaltelement 92 im elektrisch leitfähigen Zustand ist, gleich lang wie die Zeitspanne ist, in der das erste Schaltelement 20 geöffnet ist, wird bei Betrieb dem Energiespeicher 18 über die zweite Spule 12 sowie das erste Schaltelement 92 nahezu gleich viel Energie entzogen, wie über die dritte Spule 98 sowie die Diode 100 zurück gespeist wird. Somit schwankt die Ladespannung des Energiespeichers 18 lediglich geringfügig, und ein elektrischer Stromfluss über den fünften und sechsten Widerstand 104, 106 ist vergleichsweise gering.

Falls mittels des Hauptstrompfads der Hauptstrom geführt wird, erfolgt auch ein Stromflusses durch die erste Spule 10, mittels derer daher ein Magnetfeld erstellt wird. Daher erfolgt ebenfalls eine Magnetisierung des gemeinsamen Kerns, auf den auch die zweite und dritte Spule 12, 98 gewickelt sind. Somit wird die Induktivität der zweiten und dritten Spule 12, 98 verändert. Infolgedessen ergibt sich eine Differenz zwischen der dem Energiespeicher 18 entnommenen und zurückgespeisten Energie, wenn das erste Schaltelement 92 getaktet betrieben wird.

Somit sinkt die Ladespannung des Energiespeichers 18, und die über die Reihenschaltung aus dem fünften und sechsten Widerstand 104, 106 anfallende elektrische Spannung steigt an. Falls hierbei die über den sechsten Widerstand 106 anfallende elektrische Spannung einen bestimmten Wert überschreitet, beispielsweise 0,6 V, wird das zweite Schaltelement 108 elektrisch leitend geschaltet. Infolgedessen fällt auch über den siebten Widerstand 110 eine elektrische Spannung an, und auch folglich liegt an dem Ausgang 22 der Vorrichtung 8 zur Erkennung des aufgrund eines Fehlers hervorgerufenen Stroms im Vergleich zu Masse 40 eine elektrische Spannung an. Somit ist dann, wenn an dem Ausgang 22 gegenüber Masse 40 eine elektrische Potentialdifferenz vorhanden ist, also insbesondere ein High-Signal vorliegt, ein aufgrund eines Fehlers hervorgerufener Strom vorhanden, der beispielsweise aufgrund eines (Stör-)Lichtbogens entstanden ist. Folglich wird der durch zweite Spule 12 fließende elektrische Strom mit einem Grenzwert verglichen, wobei der Grenzwert anhand des fünften und sechsten Widerstands 104, 106 vorgegeben ist. Auch ist der Ausgang 22 mittels der zweiten Einheit 16 in Abhängigkeit des Vergleichs angesteuert.

Je nach Fehler ist bei einem Vorliegenden Hauptstrom möglich, dass ein zusätzlicher Stromfluss mittels der dritten Spule 98 erzeugt wird, sodass die Ladespannung des Energiespeichers 18 vergleichsweise stark steigt. Aufgrund der weiteren Diode 96 wird diese Spannung auf den Glättungskondensator 56 abgeführt, sodass der Energiespeicher 18 vergleichsweise klein dimensioniert werden kann. Somit ist eine vergleichsweise schnelle Auslösung, also ein Anlegen des entsprechenden Signals an dem Ausgang 22 realisierbar.

Falls der aufgrund eines Fehlers hervorgerufene Strom vergleichsweise groß ist, wird das mittels der ersten Spule 10 erstellte Magnetfeld vergleichsweise groß, sodass der gemeinsame Kern in die Sättigung getrieben wird. Infolgedessen ist die Induktivität der zweiten Spule 12 vergleichsweise stark reduziert, da die verstärkende Wirkung des Kerns entfällt. Somit wird mittels der Induktivität der zweite Spule 12 nicht mehr ein Stromanstieg begrenzt, weswegen bei Betätigung des ersten Schaltelements 92 der Energiespeicher 18 im Wesentlichen kurzgeschlossen wird, und sich somit im Wesentlichen unverzüglich gegen Masse 40 entlädt. Aufgrund dessen fällt die zwischen der dritte Klemme 54 und Masse 40 anliegende elektrische Spannung ebenfalls über den fünften und sechsten Widerstand 104, 106 ab, und das zweite Schaltelement 108 wird ebenfalls im Wesentlichen unverzüglich leitfähig. Infolgedessen liegt wiederum an dem Ausgang 22 das Signal an, also eine elektrische Spannung gegen Masse 40, und somit ein Pegel. Infolgedessen wird bei einem vergleichsweise großen aufgrund eines Fehlers hervorgerufenen Stroms dieser vergleichsweise unverzüglich identifiziert und mittels des Ausgangs 22 ausgegeben.

Bei Beginn des Betriebs des Schutzschalters 2 ist der Energiespeicher 18 ungeladen. Somit würden über den fünften und sechsten Widerstand 104, 106 kurzzeitig die elektrische Spannung zwischen der dritten Klemme 54 und Masse 40 anfallen, weswegen das zweite Schaltelement 108 betätigt würde. Infolgedessen würde auch an dem Ausgang 22 das Signal anliegen, das bei einem aufgrund eines Fehlers hervorgerufenen Stroms / Fehler vorhanden ist. Damit dies nicht erfolgt, ist das weitere Schaltelement 94 vorhanden, dessen Steuereingang über einen achten Widerstand 112 sowie einen fünften Kondensator 114 gegen Masse 40 geführt ist.

Bei Beginn der Bestromung ist auch der fünfte Kondensator 114 ungeladen, weswegen bei Anlegen einer elektrischen Spannung an die dritte Klemme 54 ein elektrischer Strom durch das weitere Schaltelement 94 und den achten Widerstand 112 fließt. Somit wird das weitere Schaltelement 94 in den elektrisch leitenden Zustand versetzt, sodass der fünfte und sechste Widerstand 104,106 elektrisch überbrückt sind. Infolgedessen wird der Energiespeicher 18 vergleichsweise schnell geladen. Falls der Energiespeicher 18 vollständig geladen ist, ist ein Basisstrom durch das weitere Schaltelement 94 nicht mehr möglich, weswegen das weitere Schaltelement 94 in den elektrisch sperrenden Zustand überführt wird.

Bei Abschalten der Vorrichtung 8 erfolgt ein Entladen des fünften Kondensators 114 über eine zusätzliche Diode 116, die zwischen den fünften Kondensator 114 und die dritte Klemme 54 geschaltet ist. Somit ist auch bei erneutem Betrieb der Vorrichtung 8 oder des vollständigen Schutzschalters 2 der fünfte Kondensator 114 umgeladen, sodass das weitere Schaltelement 94 bei erneuter Anlegen einer elektrischen Spannung an der dritten Klemme 54 in den elektrisch leitenden Zustand versetzt wird.

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit dem Ausführungsbeispiel beschriebene Einzelmerkmale auch auf andere Weise miteinander kombinierbar, ohne den Gegenstand der Erfindung zu verlassen.

## Patentansprüche

1. Verfahren (26) zum Erkennen eines aufgrund eines Fehlers, insbesondere Lichtbogens, hervorgerufenen Stroms in einem Hauptstrompfad (4), der eine erste Spule (10) aufweist, die eine Wicklung mit mehreren Windungen aufweist, und die induktiv mit einer zweiten Spule (12) gekoppelt ist, bei welchem
- an die zweite Spule (12) eine elektrische Spannung angelegt wird,
- ein sich durch die zweite Spule (12) ergebender elektrischer Strom erfasst wird,
- der elektrische Strom mit einem Grenzwert verglichen wird, und
- in Abhängigkeit des Vergleichs auf das Vorhandensein des Fehlers geschlossen wird,
**dadurch gekennzeichnet,**
**dass** elektrisch antiparallel zur zweiten Spule (12) eine dritte Spule (98) geschaltet ist, die mit der zweiten Spule (12) induktiv gekoppelt ist.

2. Verfahren (26) nach Anspruch 1,
**dadurch gekennzeichnet,**
**dass** mittels des Hauptstrompfads (4) ein Gleichstrom geführt wird.

3. Verfahren (26) nach Anspruch 1 oder 2,
**dadurch gekennzeichnet,**
**dass** eine gepulste elektrische Spannung angelegt wird.

4. Verfahren (26) nach einem der Ansprüche 1 bis 3,
**dadurch gekennzeichnet,**
**dass** mittels des sich durch die zweite Spule (12) ergebenden elektrischen Stroms ein Energiespeicher (18) geladen wird.

5. Vorrichtung (8) zum Erkennen eines aufgrund eines Fehlers hervorgerufenen Stroms,
- die einen Hauptstrompfad (4) mit einer ersten Spule (10) aufweist, die eine Wicklung mit mehreren Windungen aufweist, und die induktiv mit einer zweiten Spule (12) gekoppelt ist, und
- die eine erste Einheit (14) zum Anlegen einer elektrischen Spannung an der zweiten Spule (12) aufweist, und
- die eine zweite Einheit (16) zum Erfassen eines sich durch die zweite Spule (12) ergebenden elektrischen Stroms und zum Vergleich des elektrischen Stroms mit einem Grenzwert aufweist, und
- die einen Ausgang (22) aufweist, der mittels der zweiten Einheit (16) in Abhängigkeit des Vergleichs angesteuert ist,
**dadurch gekennzeichnet,**
**dass** elektrisch antiparallel zur zweiten Spule (12) eine dritte Spule (98) geschaltet ist, die mit der zweiten Spule (12) induktiv gekoppelt ist.

6. Vorrichtung (8) nach Anspruch 5,
**dadurch gekennzeichnet,**
**dass** elektrisch in Reihe mit der zweiten Spule (12) ein erstes Schaltelement (92) der ersten Einheit (14) geschaltet ist, das mittels eines Taktgebers (72) der ersten Einheit (14) betätigt ist.

7. Vorrichtung (8) nach einem der Ansprüche 5 bis 6,
**dadurch gekennzeichnet,**
**dass** elektrisch parallel zur zweiten Spule (12) ein Energiespeicher (18) der zweiten Einheit (16) geschaltet ist.

8. Vorrichtung (8) nach Anspruch 7,
**dadurch gekennzeichnet,**
**dass** die zweite Einheit (16) einen parallel zum Energiespeicher (18) geschalteten Zweig (102) aufweist, der ein zweites Schaltelement (92) umfasst, das in Abhängigkeit einer über den Energiespeicher (18) anfallenden elektrischen Ladespannung betätigt ist, wobei der Ausgang (22) gegen den Zweig (102) geführt ist.

9. Schutzschalter (2) mit einem Hauptstrompfad (4), der ein drittes Schaltelement (6) aufweist, und mit einer Vorrichtung (8) zum Erkennen eines aufgrund eines Fehlers hervorgerufenen Stroms nach einem der Ansprüche 5 bis 8, mittels derer das dritte Schaltelement (6) betätigt ist.

## Claims

1. Method (26) for identifying a current brought about due to a fault, in particular an arc, in a main current path (4) comprising a first coil (10) that comprises a winding with a plurality of turns and that is inductively coupled to a second coil (12), in which method
- a voltage is applied to the second coil (12),
- an electric current produced by the second coil (12) is detected,
- the electric current is compared with a limit value, and
- the presence of the fault is deduced on the basis of the comparison,
**characterized**
**in that** a third coil (98) is electrically connected in antiparallel with the second coil (12) and is inductively coupled to the second coil (12).

2. Method (26) according to Claim 1,
**characterized**
**in that** a DC current is carried by means of the main current path (4).

3. Method (26) according to Claim 1 or 2,
**characterized**
**in that** a pulsed voltage is applied.

4. Method (26) according to one of Claims 1 to 3,
**characterized**
**in that** an energy storage unit (18) is charged by means of the electric current produced by the second coil (12).

5. Device (8) for identifying a current brought about due to a fault,
- which comprises a main current path (4) with a first coil (10) that comprises a winding with a plurality of turns and that is inductively coupled to a second coil (12), and
- which comprises a first unit (14) for applying a voltage to the second coil (12), and
- which comprises a second unit (16) for detecting an electric current produced by the second coil (12) and for comparing the electric current with a limit value, and
- which comprises an output (22) that is actuated by means of the second unit (16) on the basis of the comparison,
**characterized**
**in that** a third coil (98) is electrically connected in antiparallel with the second coil (12) and is inductively coupled to the second coil (12).

6. Device (8) according to Claim 5,
**characterized**
**in that** a first switching element (92) of the first unit (14) is electrically connected in series with the second coil (12) and is activated by means of a clock generator (72) of the first unit (14).

7. Device (8) according to either of Claims 5 and 6, **characterized**
**in that** an energy storage unit (18) of the second unit (16) is electrically connected in parallel with the second coil (12).

8. Device (8) according to Claim 7,
**characterized**
**in that** the second unit (16) comprises a branch (102) that is connected in parallel with the energy storage unit (18) and that comprises a second switching element (92) that is activated on the basis of a charging voltage dropped across the energy storage unit (18), wherein the output (22) is routed to the branch (102).

9. Circuit breaker (2) having a main current path (4) that comprises a third switching element (6), and having a device (8) for identifying a current brought about due to a fault according to one of Claims 5 to 8, by means of which the third switching element (6) is activated.

## Revendications

1. Procédé (26) permettant d'identifier un courant provoqué en raison d'un défaut, en particulier d'un arc électrique, dans un chemin de courant principal (4) qui présente une première bobine (10) qui présente un enroulement à plusieurs spires et qui est couplée par induction à une deuxième bobine (12), dans lequel
- une tension électrique est appliquée à la deuxième bobine (12),
- un courant électrique résultant de la deuxième bobine (12) est détecté,
- le courant électrique est comparé avec une valeur limite, et
- en fonction de la comparaison, la présence du défaut est déterminée,
**caractérisé en ce qu'**une troisième bobine (98), qui est couplée par induction à la deuxième bobine (12), est montée de manière antiparallèle à la deuxième bobine (12).

2. Procédé (26) selon la revendication 1, **caractérisé en ce qu'**un courant continu est acheminé au moyen du chemin de courant principal (4).

3. Procédé (26) selon la revendication 1 ou 2, **caractérisé en ce qu'**une tension électrique pulsée est appliquée.

4. Procédé (26) selon l'une quelconque des revendications 1 à 3, **caractérisé en ce qu'**un accumulateur d'énergie (18) est chargé au moyen du courant électrique résultant de la deuxième bobine (12) .

5. Dispositif (8) permettant d'identifier un courant provoqué en raison d'un défaut,
- qui présente un chemin de courant principal (4) pourvu d'une première bobine (10) qui présente un enroulement à plusieurs spires et qui est couplée par induction à une deuxième bobine (12), et
- qui présente une première unité (14) pour appliquer une tension électrique à la deuxième bobine (12), et
- qui présente une deuxième unité (16) pour détecter un courant électrique résultant de la deuxième bobine (12) et pour comparer le courant électrique avec une valeur seuil, et
- qui présente une sortie (22) qui est pilotée au moyen de la deuxième unité (16) en fonction de la comparaison,
**caractérisé en ce qu'**une troisième bobine (98), qui est couplée par induction à la deuxième bobine (12), est montée de manière antiparallèle à la deuxième bobine (12).

6. Dispositif (8) selon la revendication 5, **caractérisé en ce qu'**un premier élément de commutation (92) de la première unité (14) est monté électriquement en série avec la deuxième bobine (12) et qui est actionné au moyen d'une horloge (72) de la première unité (14).

7. Dispositif (8) selon l'une quelconque des revendications 5 à 6, **caractérisé en ce qu'**un accumulateur d'énergie (18) de la deuxième unité (16) est monté électriquement en parallèle avec la deuxième bobine (12).

8. Dispositif (8) selon la revendication 7, **caractérisé en ce que** la deuxième unité (16) présente une branche (102) montée en parallèle à l'accumulateur d'énergie (18), qui comprend un deuxième élément de commutation (92) qui est actionné en fonction d'une tension de charge électrique apparaissant aux bornes de l'accumulateur d'énergie (18), dans lequel la sortie (22) est amenée à la branche (102).

9. Disjoncteur de protection (2), comprenant un chemin de courant principal (4) qui présente un troisième élément de commutation (6), et un dispositif (8) permettant d'identifier un courant provoqué en raison d'un défaut selon l'une quelconque des revendications 5 à 8, au moyen duquel le troisième élément de commutation (6) est actionné.
